# EUROPEAN PATENT SPECIFICATION

(11) **EP 4 066 376 B1**
(45) Date of publication and mention of the grant of the patent: **23.04.2025**
(21) Application number: 20891868.0
(22) Date of filing: 24.11.2020
(51) Int. Cl.: H02S 30/10, H01L 31/02, F24S 25/20

(54) **PHOTOVOLTAIC FRAME WITH LAMINATE RECEIVER**
FOTOVOLTAIKRAHMEN MIT LAMINATAUFNAHME
CADRE DE PANNEAU PHOTOVOLTAÏQUE DOTÉ D'UN RÉCEPTEUR DE STRATIFIÉ

(30) Priority: 25.11.2019 US 201962939880 P; 23.11.2020 US 202017101268
(43) Date of publication of application: 05.10.2022
(73) Proprietor: Maxeon Solar Pte. Ltd., Singapore 018981 (SG)
(72) Inventor: SHAKIR, Arbaz, San Jose, CA 95134 (US); LANCE, Tamir, San Jose, CA 95134 (US); SEYMOUR, Lydia Alicia, San Jose, CA 95134 (US); FLORES, Jose Cornelio M., San Jose, CA 95134 (US); SCHULTE, Elizabeth, San Jose, CA 95134 (US)
(74) Representative: Gamba, Alessandro
(86) International application number: PCT/US2020/061908
(87) International publication number: WO 2021/108340

(56) References cited:
- DE-A1- 102009 020 256
- DE-U1- 202009 005 145
- JP-A- 2011 165 940
- KR-A- 20140 040 792
- US-A1- 2014 182 661
- US-A1- 2014 182 661
- US-A1- 2014 196 767
- US-A1- 2017 163 210
- US-A1- 2018 212 555
- US-A1- 2019 301 771
- US-B2- 8 258 395
- US-B2- 8 505 254

## Description

### RELATED APPLICATION

### BACKGROUND

Photovoltaic (PV) cells, commonly known as solar cells, are devices for conversion of solar radiation into electrical energy. Generally, solar radiation impinging on the surface of, and entering into, the substrate of a solar cell creates electron and hole pairs in the bulk of the substrate. The electron and hole pairs migrate to p-doped and n-doped regions in the substrate, thereby creating a voltage differential between the doped regions. The doped regions are connected to the conductive regions on the solar cell to direct an electrical current from the cell to an external circuit. When PV cells are combined in an array, such as a PV module, the electrical energy collected from all of the PV cells can be combined in series and parallel arrangements to provide power with a certain voltage and current.

PV modules, which may comprise PV laminates and related electronics, are often supported by a frame assembly of one or more numerous components. These frame assemblies can be secured to PV modules, can serve to hold PV modules in place, and can serve to hold PV modules in relative position to each other. The frame assemblies can be secured to supports, which themselves hold the frame assemblies and PV modules of PV systems in place. The frame assemblies can also couple with underlying buildings, foundations, or other support structures of a PV system or portions of a PV system.

US 2017/163210 A1 discloses a photovoltaic laminate frame system according to the preamble of claim 1.

### BRIEF DESCRIPTION OF THE DRAWINGS

Figures 1A-1B illustrate cross-sectional views of a frame section with laminate receiver and adhesive channel before and after insertion of a PV laminate, as may be employed, according to some embodiments.
Figures 2A-2D illustrate cross-sectional views of frame sections with laminate receiver and one or more adhesive channels, as may be employed, according to some embodiments.
Figures 3A-3D illustrate cross-sectional views of frame sections with laminate receiver and one or more adhesive channels, as may be employed, according to some embodiments.
Figures 4A-4H illustrate cross-sectional views of frame sections with laminate receiver and one or more adhesive channels, as may be employed, according to some embodiments.
Figures 5A-5C illustrate cross-sectional views of frame sections receiving PV laminates with different edge details in a laminate receiver, as may be employed, according to some embodiments.
Figures 6A-6C illustrate cross-sectional views of frame sections with stacking protrusions and stacking recesses, as may be employed, according to some embodiments.
Figures 7A-7B illustrate cross-sectional views of frame sections coupled to an anchor transition and further secured by a frame anchor, as may be employed, according to some embodiments.
Figure 8 illustrates labelled widths and lengths of a laminate receiver, as may be employed, according to some embodiments.

### DETAILED DESCRIPTION

The following detailed description is merely illustrative in nature and is not intended to limit the embodiments of the subject matter of the application or uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions and/or context for terms found in this disclosure (including the appended claims):
"Comprising." This term is open-ended. As used in the appended claims, this term does not foreclose additional structure or steps.
"Configured To." Various units or components may be described or claimed as "configured to" perform a task or tasks. In such contexts, "configured to" is used to connote structure by indicating that the units/components include structure that performs those task or tasks during operation. As such, the unit/component can be said to be configured to perform the task even when the specified unit/component is not currently operational (e.g., is not on/active). Reciting that a unit/circuit/component is "configured to" perform one or more tasks is expressly intended not to invoke 35 U.S.C. §112(f) for that unit/component.
"First," "Second," etc. As used herein, these terms are used as labels for nouns that they precede, and do not imply any type of ordering (e.g., spatial, temporal, logical, etc.). For example, reference to a "first" frame member does not necessarily imply that this frame member is the first frame member in a sequence; instead the term "first" is used to differentiate this frame member from another frame member (e.g., a "second" frame member).
"Based On." As used herein, this term is used to describe one or more factors that affect a determination. This term does not foreclose additional factors that may affect a determination. That is, a determination may be solely based on those factors or based, at least in part, on those factors. Consider the phrase "determine A based on B." While B may be a factor that affects the determination of A, such a phrase does not foreclose the determination of A from also being based on C. In other instances, A may be determined based solely on B.
"Coupled" - The following description refers to elements or nodes or features being "coupled" together. As used herein, unless expressly stated otherwise, "coupled" means that one element/node/feature is directly or indirectly joined to (or directly or indirectly communicates with) another element/node/feature, and not necessarily mechanically.
"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, and/or effect which might otherwise occur. Accordingly, when a component, element, or feature is referred to as inhibiting a result or state, it need not completely prevent or eliminate the result or state.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The terminology used herein is for the purpose of describing particular embodiments only and is not intended to be limiting of the invention. As used herein, the singular forms "a," "an" and "the" are intended to include plural forms as well, unless the context clearly indicates otherwise.

As used herein, the terms "about" or "approximately" in reference to a recited numeric value, including for example, whole numbers, fractions, and/or percentages, generally indicates that the recited numeric value encompasses a range of numerical values (e.g., +/- 5 % to 10% of the recited value) that one of ordinary skill in the art would consider equivalent to the recited value (e.g., performing substantially the same function, acting in substantially the same way, and/or having substantially the same result). As used herein, the terms "about" or "approximately" in reference to a recited non-numeric parameter generally indicates that the recited non-numeric parameter encompasses a range of parameters that one of ordinary skill in the art would consider equivalent to the recited parameter (e.g., performing substantially the same function, acting in substantially the same way, and/or having substantially the same result).

Recitation of ranges of values herein are merely intended to serve as a shorthand method of referring individually to each separate value falling within the range, unless otherwise indicated herein, and each separate value is incorporated into the specification as if it were individually recited herein.

In the following description, numerous specific details are set forth, such as specific operations, in order to provide a thorough understanding of embodiments of the present disclosure. It will be apparent to one skilled in the art that embodiments of the present disclosure may be practiced without these specific details. In other instances, well-known techniques are not described in detail in order to not unnecessarily obscure embodiments of the present disclosure.

The invention is directed towards a PV frame system. Examples, not part of the present invention, may comprise photovoltaic (PV) frames, methods of PV manufacture, articles of PV manufacture, and processes involving PVs. The frames employ a PV laminate receiver configured to receive one or more surface of a PV laminate and support that PV laminate upon installation of a PV system. The laminate receivers employ adhesive channels. These one or more channels may manage flow and/or seating of adhesive in the laminate receiver when a surface of a PV laminate is inserted into or is within a laminate receiver. In embodiments, the frames may employ stacking recesses and stacking protrusions along their length. The protrusions and recesses may be positioned and sized to allow for stacking of frames and, sometimes, self-centering stacking of frames in some embodiments. The frames and systems including these frames may comprise various materials including metal, metal alloys, ceramics, polymers, and combinations thereof.

The laminate receivers have an upper flange and a lower flange as well as one or more channels for adhesive flow. Laminate receivers comprise one or more laminate stops configured to align a laminate within the laminate receiver. A bead or multiple beads of adhesive, which is room temperature vulcanizing (RTV) silicone, are placed on or around a surface of the laminate receiver or the PV laminate or both, and the laminate and the laminate receiver may be brought together with the adhesive filling some or all gaps in between the two mating components. The laminate receiver includes one or more channels in which the adhesive may flow during assembly and/or until curing is complete. The laminate receiver also includes an alignment stop or stops that may be configured and serve to orient a portion of a laminate within the laminate receiver. These stops may be positioned, for example, at a back wall of a laminate receiver and may serve to prevent an edge of a laminate from fully contacting the back wall of the laminate receiver. The resulting space between the back wall and the edge of the laminate may serve as a flow channel for adhesive. Flow channels may also be formed on other areas of the laminate receiver, such as on an upper flange or a lower flange or both.

In embodiments, the flow channel may serve to create a passage in the back or side of the laminate receiver to allow RTV silicone or other RTV material or other adhesive to flow and wrap around the PV laminate more evenly. This may be suitable to provide that a sufficient amount of adhesive is present to resist uplift and downforce, loads from top clamps, and other loads. In embodiments, additional adhesive may be placed along a bottom flange of the laminate receiver as well.

In embodiments, flanges of a laminate receiver may be configured with additional features to manage adhesive flow in and around edges of a photovoltaic laminate being held in a laminate receiver. These features may also provide for reducing edge loading or pinpoint loading on PV laminate positioned in a laminate receiver. This reduced loading may serve to reduce PV laminate breakage. The configuration of the features may include grooves, dimples, coves, channels, protrusions, hooks, and flaps, among others.

The frame systems, which comprise the frames, may comprise various materials including metal, metal alloys, ceramic, polymers and combinations thereof. Thus, these frames and the other sections of the frame systems and components of embodiments may comprise various materials including metal, metal alloys, ceramic, polymers and combinations thereof.

The upper flange or other upper surface of a laminate receiver is sized to be only a portion of the size of a corresponding lower flange of the laminate receiver. For example, an upper flange may be nonexistent or may have a width of 1, 2, 3, 4 or 5 mm or more or less, while a lower flange of a laminate receiver may have a width of 1, 2, 3, 4, 5, 6, 7, 8, 9, 10, 11, 12, 13, 14, 15, 16, 17, 18, 19, 20 mm or more or less. The width of the upper flange or other upper surface of a laminate receiver may be set depending upon an expected snow load, wind load, or other load that may place a normal force or rotational moment or other load on a PV laminate supported by a laminate receiver of a frame. Likewise, the width of the lower flange or other lower surface of a laminate receiver may be set depending upon an expected snow load, wind load, or other load that may place a normal force or rotational moment or other load on a PV laminate supported by a laminate receiver of a frame. In other words, a distributed load across a face of a laminate may cause rotational forces near or at the ends of a laminate that act to urge the laminate edges out of a laminate receiver of a supporting frame. Likewise, a distributed load across a face of a laminate may cause rotational forces near or at the middle, ends, or both of a laminate that act to urge the laminate edges out of a laminate receiver of a supporting frame. The width of the upper flange or other upper surface of a laminate receiver, the lower flange or other lower surface of a laminate receiver, or both, may be set depending on the expected strength of such forces, or based on other factors, or both. Minimizing the size of the upper flange can serve to provide greater exposed surface area for PV laminates in the laminate receiver and supported by the frame.

In some embodiments, the lower flange of the frame may be sloped and have one or more slopes or pitches along its width. This slope may serve to reduce edge loading concentrations on a PV laminate and thereby inhibit breakage of the PV laminate. In some embodiments, the laminate receiver may sit atop or otherwise be connected to a single wall frame section while in other embodiments, double wall, triple wall or other multiple wall configurations may be employed. The laminate receiver may be cantilevered over an exposed outer wall or may be aligned with one or more outer walls. The laminate receiver may have a triangular cross-section and may be connected to a portion of the wall. This connection may serve to transfer torque or other forces from the laminate receiver to a wall or other portion of a frame.

In embodiments, the frames may be configured with one or more beveled surfaces or chamfered surfaces to provide for alignment during stacking. This stacking may occur during transport or other pre-assembly steps. Stacking protrusions and recesses of a frame may serve to self-center frames stacked atop one another or otherwise placed together. Alignment surfaces may be grooved, and the grooves may provide friction as well as tactile signals beneficial while stacking the frames. This self-centering feature may be created by beveled edges or other surfaces on different portions of the frame where these beveled or biased surfaces urge mating frame sections to self-center when mated. For example, a left-side bevel may be at - 45 ° and a right-side bevel may be + 45°. These mirrored angels may then guide a mating piece towards a center location or other target mating location.

Frame inserts may be employed and may be coupled to insert spacings along exposed surfaces of the frame sections. The frame inserts may be configured to integrate with frame clamps, which can serve to secure the frames to sub-frame assemblies or a support structure.

Embodiments may include a photovoltaic (PV) laminate double-wall support frame comprising two upright walls spaced apart from each other and each wall having a length; an upper connector connecting upper sections of the two upright walls to each other along the length of the walls; and a PV laminate receiver positioned above the upper connector, the laminate receiver having a top flange, a first PV laminate stop, and adhesive flow channel, the flow channel formed in an exposed inner surface of the laminate receiver, the top flange having a perimeter edge a majority of which does not extend beyond both upright walls. In embodiments, the support frame may have a wall that extends below the upper connector and connects to one of the two upright walls. In embodiments, the laminate receiver may have sides that form a triangle when the laminate receiver is viewed in cross-section and/or the exposed inner surface may be an upright side of the laminate receiver. In embodiments, a lower connector may be employed with the lower connector connecting lower sections of the two upright walls to each other along the length of the walls. Moreover, the lower connector may have a flange, the flange extending beyond an outer surface of an upright wall, the flange may have a lower perimeter surface, the lower perimeter surface having a chamfer along a length of the lower perimeter surface. Still further in embodiments, the two upright walls may have different heights, and/or the perimeter edge of the laminate receiver may not extend beyond either upright wall.

In embodiments, a top flange of the laminate receiver may have a plurality of exposed groves along a top surface of the top flange, the grooves oriented lengthwise along the top flange. And in embodiments, a top flange may have a triangular cross section.

In embodiments, a support frame may comprise a second PV laminate stop. Moreover, a first PV laminate stop and a second PV laminate stop may be positioned opposite each other and may be positioned on one or more accessible internal surface of the laminate receiver. The PV laminate receiver may also have a beveled top surface.

Examples, not part of the present invention, may also comprise a photovoltaic (PV) laminate frame system comprising a PV laminate having a plurality of external edges and a plurality of PV cells; adhesive; and a plurality PV frame sections, wherein at least one of the frames of the plurality comprises: a PV laminate receiver, the PV laminate receiver having an upper surface, a lower surface spaced apart from upper surface, a connecting surface connecting the upper surface to the lower surface, and a laminate stop. In embodiments, a portion of the PV laminate may be positioned within laminate receiver. In embodiments, the laminate stop may inhibit movement of the PV laminate towards at least one internal surface of the laminate receiver. In embodiments, a width of the upper surface along the upper surface length may be no more than approximately one-third of the width of the lower surface along a majority of the lower surface length. In embodiments, adhesive may be a room temperature vulcanizing (RTV) material. In embodiments, at least a laminate receiver of one of the frames of the plurality may also comprise a flow channel for the adhesive, the flow channel positioned away from an external edge of the PV laminate when the PV laminate is seated in the laminate receiver.

In embodiments, each of the frame sections of the plurality of frame sections may comprise a double-wall channel and a chamfered edge along an external surface of the double-wall channel.

In embodiments, an upper surface of the laminate receiver may have a grooved exposed surface, the grooved exposed surface having a triangular cross-section along at least a portion of its length.

The invention includes a photovoltaic (PV) laminate frame system comprising a first PV laminate having a peripheral surface and a plurality of PV cells; a room temperature vulcanizing silicone; and an elongated PV frame section comprising: a PV laminate receiver, the receiver having an upper surface, a lower surface spaced apart from the upper surface, a connecting surface connecting the upper surface to the lower surface, a flow channel exposed to permit flow of the silicone in the channel, and a laminate stop, the laminate stop integral with the PV laminate receiver. A portion of the PV laminate is positioned within the laminate receiver, wherein the laminate stop inhibits movement of the PV laminate towards at least one internal surface of the laminate receiver. A width of the upper surface along the upper surface length may be no more than one-half of the width of the lower surface along a majority of the lower surface length, and at least facing surfaces of the lower surface and the upper surface may not be parallel.

In embodiments, the elongated PV frame section may comprise a metal alloy, metal, ceramic, polymer and combinations thereof. In embodiments, the flow channel may be positioned away from the peripheral surface of the first PV laminate when the PV laminate is seated in the laminate receiver. In embodiments, the frame section may comprise a double-wall channel and a chamfered edge along an external surface of the double-wall channel and/or the upper surface of the laminate receiver may have a grooved exposed surface, the grooved exposed surface having a triangular cross-section along at least a portion of its length.

In embodiments, a clamping or securement force exerted by the frame onto the PV laminate may be adjusted through changes in the upper flange, the lower flange, the amount of RTV silicone or other adhesive, as well as other adjustments in the designs and systems taught herein. Design criteria may consider reduction in clamping force on the PV laminate through one or more of these design adjustments as well as a potential uplift failure resulting from adhesive pullout if the adhesive coverage changes or is designed away.

Embodiments may provide compatibility with a variety of frame anchor clamp geometries and may provide suitable surface area for the clamp to sit on and may include: (1) allowing frame anchor clamp laminate receiver to be used between adjacent laminates with an adapter, (2) allowing use of an adapter to locally increase the surface area of flanges of the laminate receiver, (3) increasing surface area of PV laminate interface to extending beyond an outer web wall, and/or (4) adjusting the size of the laminate receiver to suit or maximize power/efficiency requirements.

Preferred embodiments may provide for PV laminate penetration depth of approximately 4 mm or more into the laminate receiver. A 4 mm or more penetration depth of the laminate receiver may accommodate a web/wall thickness of approximately 1.5mm in embodiments.

As described above, a built-in stacking feature(s) may be provided and may serve to reduce or eliminate supplemental plastic corner pieces. In embodiments, the stacking angle may be a function of the largest volume of material to be removed without impacting the functionality of the frame clamp or making the frame section un-extrudable.

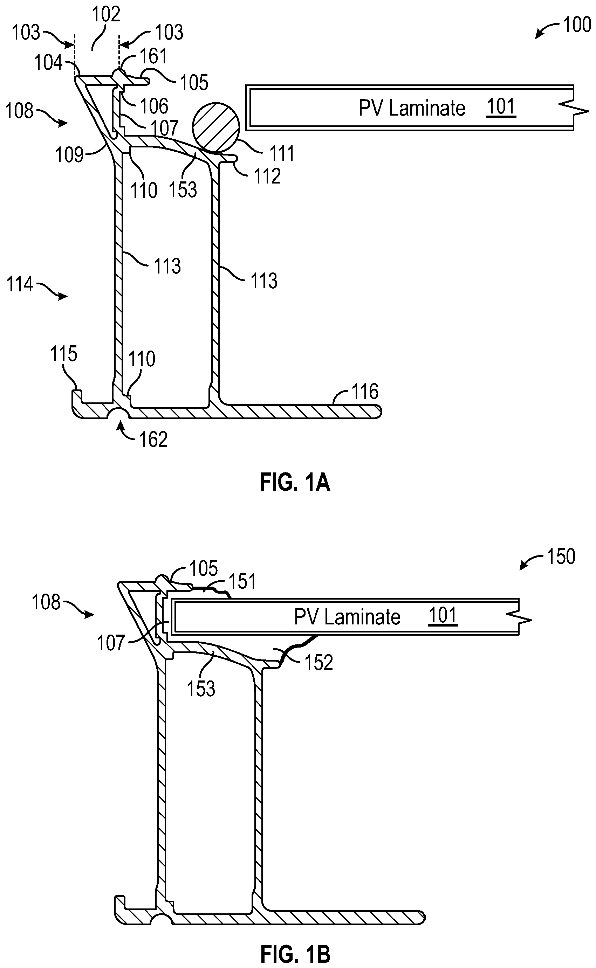

Figures 1A-1B illustrate cross-sectional views of a frame section with laminate receiver 108 and adhesive flow channel 107 before 100 and after 150 insertion of a PV laminate 101 into the laminate receiver 108, as may be employed, according to some embodiments. Labelled in Figures 1A and 1B are triangular cross-section 104, overhang width 103 of triangular cross-section 104, overhang 102 of triangular cross-section 104, laminate stops 106, adhesive flow channel 107, RTV silicone bead / adhesive 111, flange end 112, corner support 110, lower flange 153, web/wall 113, lower flange 109, frame cross-section 114, bottom flange with upturned end 115, bottom flange 116, spread RTV silicon adhesive 151, spread RTV silicone adhesive 152, upper flange 105, alignment/stacking recess 162, and alignment/stacking protrusion 161. The laminate receiver 108 is shown with an upper flange 105, adhesive flow channel 107, and lower flange 153 defining an area into which a surface of a PV laminate 101 may be inserted. The laminate channel has a smaller upper flange than a lower flange and a wall of the receiving channel may have a triangular cross-section 104. The overhang 102 of the triangular cross-section 104 may extend beyond a web/wall 113 of a frame and may be sized and configured to add rigidity to the laminate receiver 108.

As the PV laminate 101 is inserted into the laminate receiver, a bead 111 of adhesive may be compressed and may flow around the laminate and into and through the channel 107 of the laminate receiver 108. The spread location is shown at 151 and 152 of Figure 1B. After setting the adhesive the PV laminate may now be considered secure in the frame and may be secured in a PV system installation.

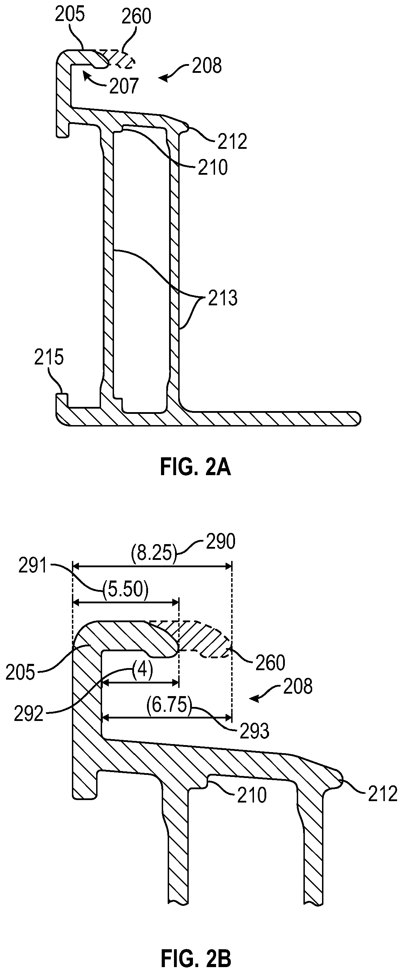

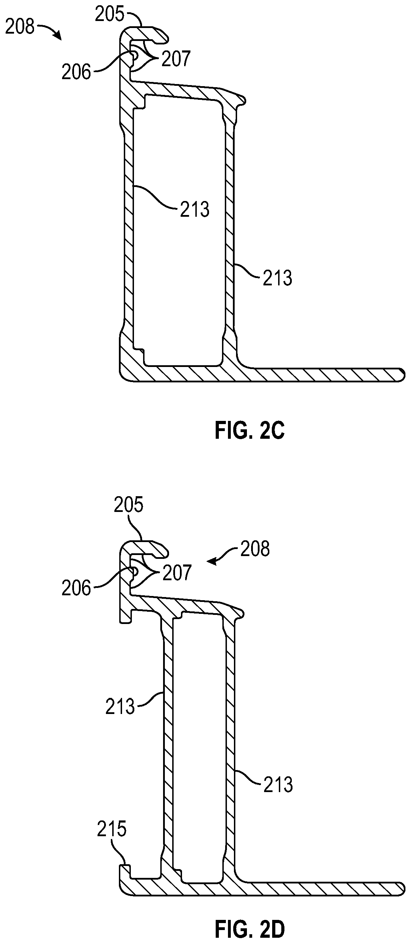

Figures 2A-2D illustrate cross-sectional views of frame sections with laminate receiver and one or more adhesive channels, as may be employed, according to some embodiments. Labelled in Figures 2A-2D are truncated upper flange 205, extended upper flange 260, laminate receiver 208, adhesive flow channel 207, flange end 212, corner support 210, web/wall 213, bottom flange with upturned end 215, and dimensions 290-93. Truncated upper flanges 205 may be employed instead of extended upper flanges 260 in embodiments. By limiting the size of the upper flange, additional light may reach the PV laminate when installed. Adhesive flow channels may be present in various surfaces of the laminate receiver. For example, an inner surface of the truncated upper flange 205 includes such a channel, as is shown in Figure 2A. Figures 2C and 2D show how adhesive flow channels may be present on upper and back surfaces of a laminate receiver in embodiments. Also shown in Figures 2C and 2D is laminate stop 206.

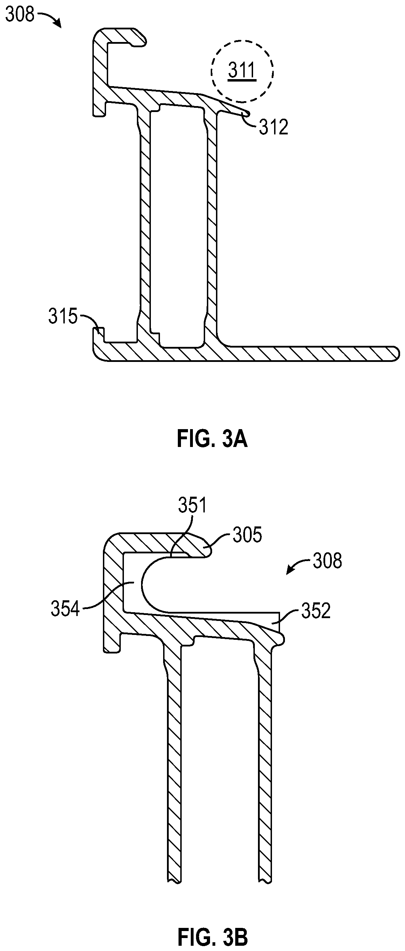

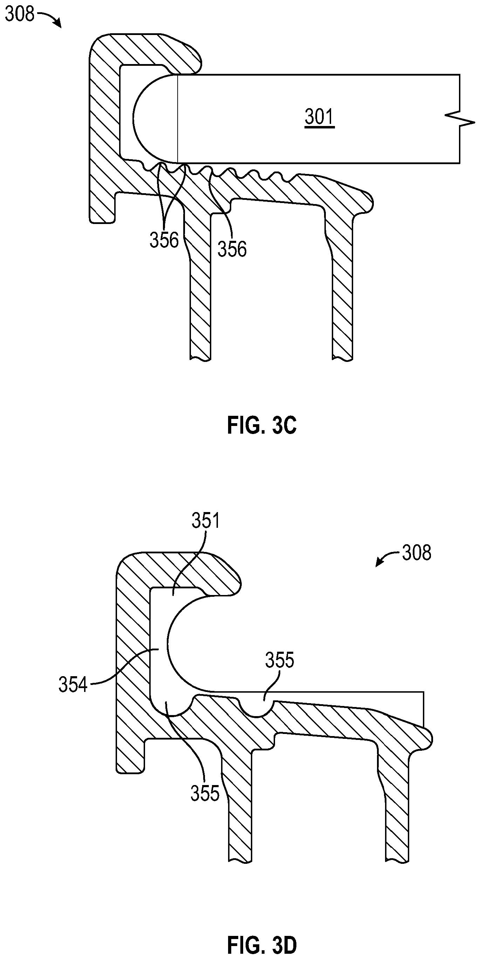

Figures 3A-3D illustrate cross-sectional views of frame sections with a laminate receiver and one or more adhesive channels as may be employed, according to some embodiments. Labelled in Figures 3A-3D are RTV silicone bead/adhesive 311, upper flange 305, lower flange end 312, bottom flange with upturned end 315, laminate receiver 308, squeezed RTV silicone / adhesive 351, squeezed RTV silicone / adhesive 352, adhesive channels 355, adhesive channels 356, PV laminate 301, and squeezed RTV silicone adhesive 354. Figures 3B and 3D show expected location of squeezed adhesive or silicone. As can be seen here, the outward surfaces of the adhesive contours to surfaces of the laminate receiver 308 and the surfaces of the PV laminate 301. As the adhesive is reconfigured during assembly from bead form 311 to its final squeezed form 351, 352, and 354, the adhesive may flow via the channels 356 or 355 or other adhesive flow channels of embodiments. In addition to allowing for adhesive flow, the flow channels may also allow for increased surface area adhesion, thereby providing for additional grip of PV laminate held in the laminate receiver 308. As can be seen at 351, the adhesive may not squeeze out past the top flange 305. The amount of adhesive employed may be managed so as to limit or eliminate squeeze out while at the same time proving for sufficient adhesion for anticipated loads. An advantage of managing adhesive or adhesive flow in this manner may be that adhesive does not reach the exposed surface of the PV laminate, thereby providing maximum solar exposure to PV cells of the PV laminate.

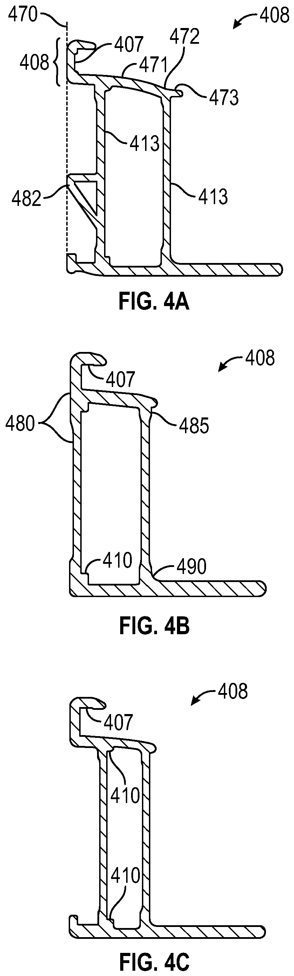

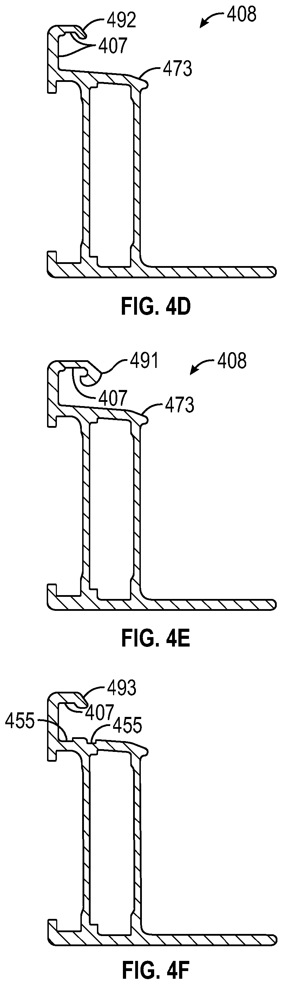

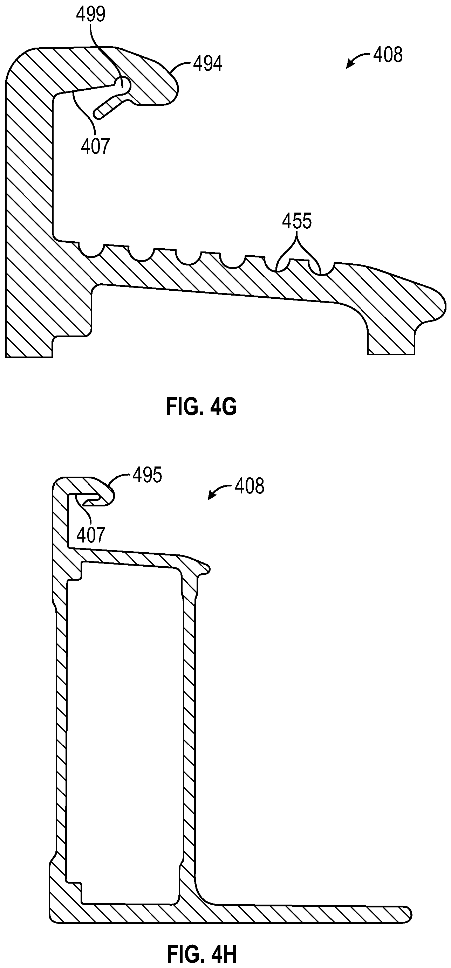

Figures 4A-4H illustrate cross-sectional views of frame sections with a laminate receiver and one or more adhesive flow channels, as may be employed, according to some embodiments. Labelled in one or more of Figures 4A-4H are laminate receiver 408, adhesive flow channel 407, three pitches (grades) on laminate receiver lower surface 471, 472, and 473, web/wall 413, reinforced corner 485, outer border alignment 470, different wall thickness 480, reinforced corner 490, corner support 410, bent end 492, hooked flange end 491, chamfered flange end 473, upper flange bent end 493, adhesive flow channel 455, upper flange flapper end 494, adhesive flow channel407, support connector 482, and hooked flange end 495. Various configurations of the upper flange end (bent, hooked, flapper, etc.) may be employed in embodiments to control adhesive/adhesive flow in and around the edge of a PV laminate. By creating a tight seal between the laminate receiver and the PV laminate, errant adhesive/adhesive flow can be minimized in some embodiments.

As can be seen in Figure 4F and 4G, the channels 455 may have different shapes and may have various locations. Here, in Figure 4F, there are two rectangular channels located close to the back wall along the bottom flange. While in Figure 4G, there are six semi-circular channels located on the bottom flange along most of its width. The upper flange in Figures 4F and 4G show still different figurations for flow channels with Figure 4F showing a flat recess while Figure 4G shows a flapper configuration with a recessed cylindrical void 499.

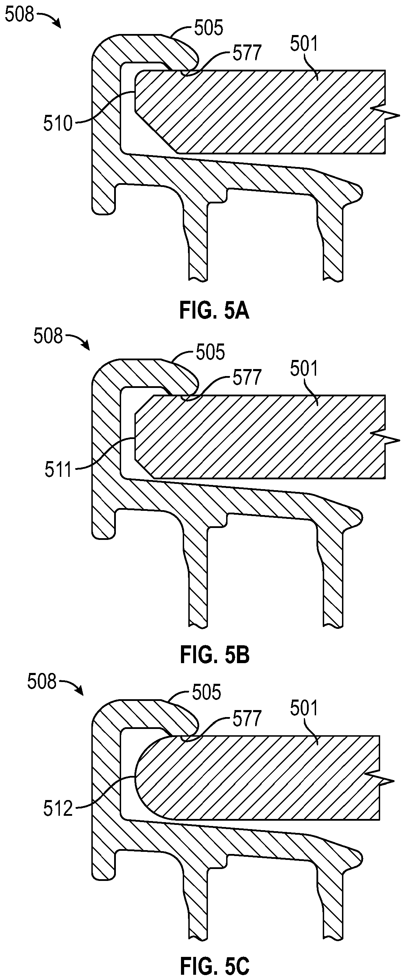

Figures 5A-5C illustrate cross-sectional views of frame sections receiving PV laminates with different edge details in a laminate receiver, as may be employed, according to some embodiments. Labelled in one or more of Figures 5A-5C are laminate receiver 508, PV laminate 501, PV laminate end with single chamfer 510, PV laminate end with double chamfer 511, and PV laminate end with bullnose 512. As can be seen in these figures, the flat surface of the PV laminate is in contact with the upper flange 505 and forms a seal 577 between the two components. Extra adhesive may flow out along the bottom surface of the PV laminate but may be retarded from flowing along an exposed top surface of the PV laminate by the seal 577 between the upper flange 505 and the PV laminate 501.

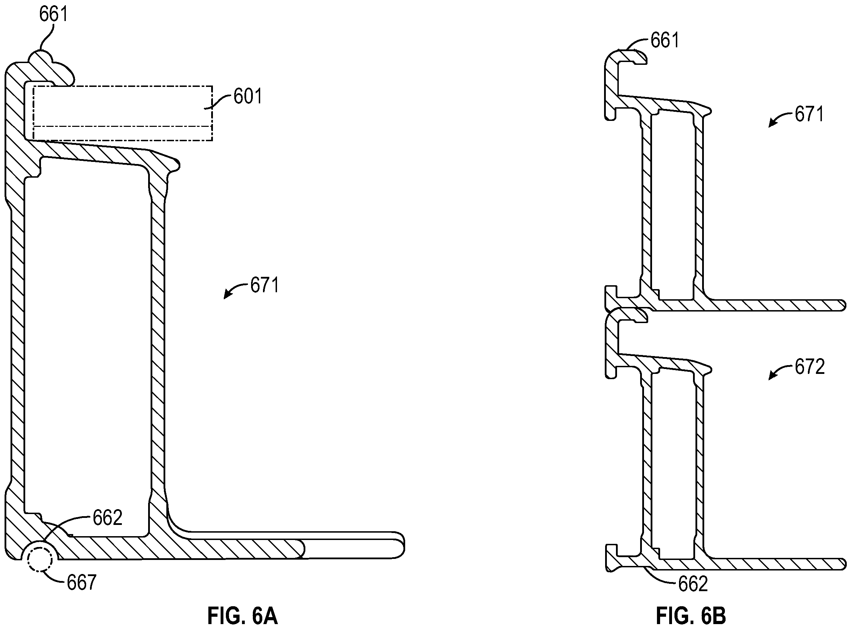

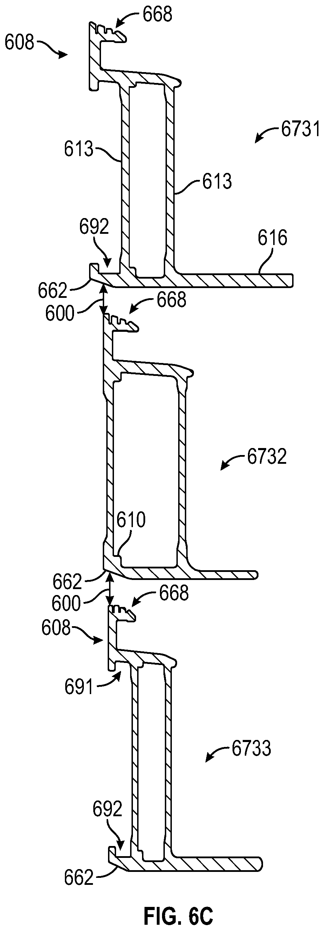

Figures 6A-6C illustrate cross-sectional views of frame sections with alignment/stacking protrusions and alignment/stacking recesses, as may be employed, according to some embodiments. The stacking protrusions and stacking recesses of embodiments may be located on outside or exposed surfaces of the frames. These protrusions and recesses may run along the length of the frames and may be continuous along the length, or may be located at intervals along the length with breaks between them. The recesses and protrusions may serve to align, self-center, or both, frames positioned atop one another. The protrusions and recesses may be located near or at outer perimeter locations of the frames. Labelled in Figures 6A-6C are stacking protrusions 661, expected PV laminate 601, first frame 671, second frame 672, stacking recess 662, expected stacking protrusion 667, chamfered/beveled stacking protrusion with grooves 668, laminate receiver 608, flange 616, web/wall 613, stacked frame 6731, stacked frame 6732, stacked frame 6733, frame insert spacing 692, direction of stacking 600, and frame insert spacing 691. The chamfered / beveled edges may be angled so as to provide self-centering bias when frames are stacked atop each other. In other words, a polygonal frame stacked atop another polygonal frame may find its center above each other because the angels of the protrusion 661 meeting the recess 662 causes the two frames to center between each other. The protrusions and recesses may be various shapes in embodiments. In preferred embodiments they can mimic the opposite of the shape of the recess or protrusion in the frame above or below so as to mate with the applicable recess or protrusion. Grooves or channels may also be present to enhance gripping and friction.

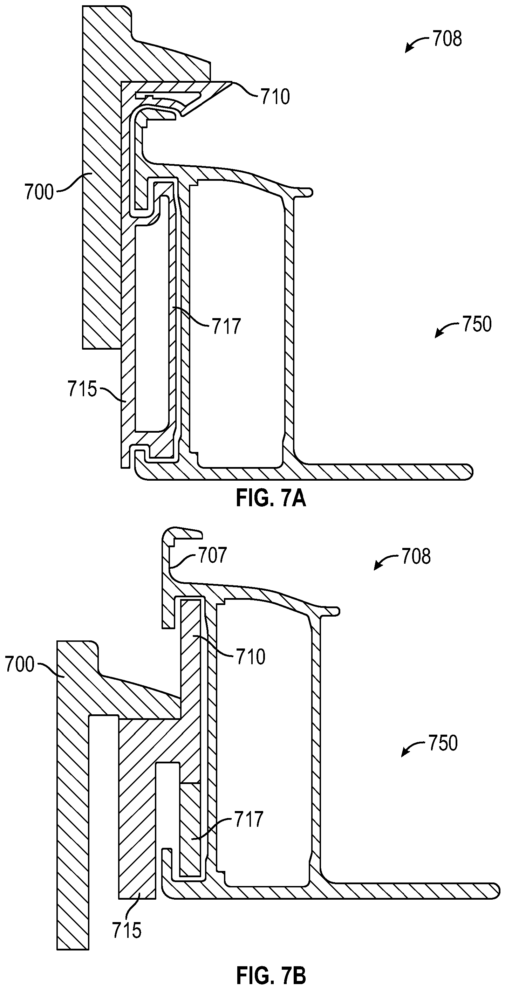

Figures 7A-7B illustrate cross-sectional views of frame sections coupled to a frame anchor clamp and further secured by a frame anchor insert as may be employed, according to some embodiments. The frame anchor clamp 700 of embodiments may serve to secure a PV frame and laminate to a support structure on a roof or elsewhere. The frame anchor inserts 710, 715, and 717 may serve to couple the frame and PV laminate to the anchor clamp 700. The insert may have upper portions 710, outside portions 715, and inner portions 717. These inner and upper portions may be configured to mate with and secure to a frame, while the outer portions may be configured to mate with and secure to a frame anchor clamp 700.

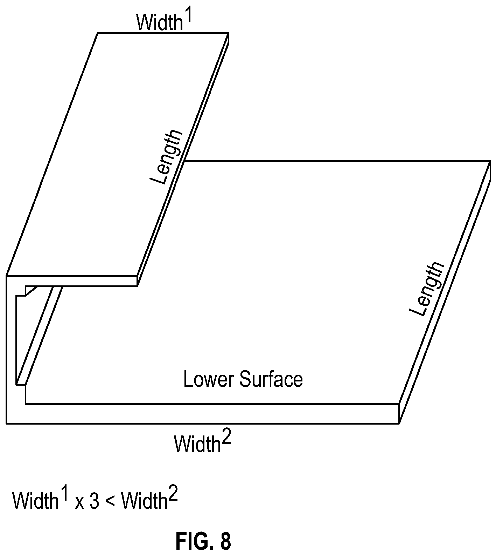

Figure 8 illustrates labelled widths and lengths of an exemplary laminate receiver, as may be employed, according to some embodiments. As can be seen, a channel is present in the back wall of the receiver and the receiver is in the shape of a "J". While various ratios may be employed in embodiments, the ratio of the width of the upper flange to the lower flange is identified in this example as being a factor of at least three. In other words, in some embodiments, the width of the lower flange is at least three time the width of the upper flange. A width of the upper surface along the upper surface length is no more than one-half of the width of the lower surface along a majority of the lower surface length.

## Claims

1. A photovoltaic laminate frame system comprising: a first PV laminate (101, 301, 501, 601) having a peripheral surface and a plurality of PV cells; a room temperature vulcanizing silicone; and an elongated PV frame section comprising: a PV laminate receiver (108, 208, 308, 408, 508, 608, 708), the PV laminate receiver (108, 208, 308, 408, 508, 608, 708) having an upper surface having a length and a width, a lower surface having a length and a width, the lower surface spaced apart from the upper surface, a connecting surface connecting the upper surface to the lower surface, a first flow channel (107, 207, 407) exposed to permit flow of the room temperature vulcanizing silicone in the PV laminate receiver (108, 208, 308, 408, 508, 608, 708), and a laminate stop (106, 206), the laminate stop (106, 206) integral with the PV laminate receiver (108, 208, 308, 408, 508, 608, 708), wherein a portion of the first PV laminate (101, 301, 501, 601) is positioned within the PV laminate receiver (108, 208, 308, 408, 508, 608, 708), wherein the laminate stop (106, 206) inhibits movement of the PV laminate (101, 301, 501, 601) towards at least one internal surface of the PV laminate receiver (108, 208, 308, 408, 508, 608, 708), wherein the photovoltaic laminate frame system is **characterized in that** a width of the upper surface along the upper surface length is no more than one-half of the width of the lower surface along a majority of the lower surface length, and wherein at least facing surfaces of the lower surface and the upper surface are not parallel.

2. The photovoltaic laminate frame system of claim 1 wherein the elongated PV frame section comprises a metal alloy.

3. The photovoltaic laminate frame system of claim 1 wherein the first flow channel (107, 207, 407) is positioned away from the peripheral surface of the first PV laminate when the PV laminate is seated in the PV laminate receiver (108, 208, 308, 408, 508, 608, 708).

4. The photovoltaic laminate frame system of claim 1 wherein the elongated PV frame section further comprises a second flow channel exposed to permit flow of the room temperature vulcanizing silicone in the PV laminate receiver (108, 208, 308, 408, 508, 608, 708).

5. The photovoltaic laminate frame system of claim 1 further comprising a PV laminate edge positioned within the PV laminate receiver (108, 208, 308, 408, 508, 608, 708).

## Patentansprüche

1. Photovoltaik-Laminat-Rahmensystem, umfassend: ein erstes PV-Laminat (101, 301, 501, 601) mit einer Umfangsfläche bzw. -oberfläche und einer Mehrzahl von PV-Zellen; ein bei Raumtemperatur vulkanisierendes Silikon; und einen länglichen PV-Rahmenabschnitt, umfassend: eine PV-Laminataufnahme (108, 208, 308, 408, 508, 608, 708), wobei die PV-Laminataufnahme (108, 208, 308, 408, 508, 608, 708) eine obere Fläche bzw. Oberfläche mit einer Länge und einer Breite, eine untere Fläche bzw. Oberfläche mit einer Länge und einer Breite, wobei die untere Fläche von der oberen Fläche beabstandet ist, eine Verbindungsfläche bzw. -oberfläche, welche die obere Fläche mit der unteren Fläche verbindet, einen ersten Strömungskanal (107, 207, 407), der freiliegt, um ein Strömen des bei Raumtemperatur vulkanisierenden Silikons in der PV-Laminataufnahme (108, 208, 308, 408, 508, 608, 708) zu ermöglichen, und einen Laminatanschlag (106, 206) aufweist, wobei der Laminatanschlag (106, 206) einstückig bzw. integral mit der PV-Laminataufnahme (108, 208, 308, 408, 508, 608, 708) ist, wobei ein Teil des ersten PV-Laminats (101, 301, 501, 601) innerhalb der PV-Laminataufnahme (108, 208, 308, 408, 508, 608, 708) positioniert ist, wobei der Laminatanschlag (106, 206) eine Bewegung des PV-Laminats (101, 301, 501, 601) in Richtung mindestens einer Innenfläche bzw. - oberfläche der PV-Laminataufnahme (108, 208, 308, 408, 508, 608, 708) hemmt, wobei das Photovoltaik-Laminat-Rahmensystem **dadurch gekennzeichnet ist, dass** eine Breite der oberen Fläche entlang der oberen Flächenlänge nicht mehr als eine Hälfte der Breite der unteren Fläche entlang eines Großteils der unteren Flächenlänge beträgt, und wobei zumindest zugewandte Flächen bzw. Oberflächen der unteren Fläche und der oberen Fläche nicht parallel sind.

2. Photovoltaik-Laminat-Rahmensystem nach Anspruch 1, wobei der längliche PV-Rahmenabschnitt eine Metalllegierung umfasst.

3. Photovoltaik-Laminat-Rahmensystem nach Anspruch 1, wobei der erste Strömungskanal (107, 207, 407) von der Umfangsfläche des ersten PV-Laminats entfernt positioniert ist, wenn das PV-Laminat in der PV-Laminataufnahme (108, 208, 308, 408, 508, 608, 708) sitzt.

4. Photovoltaik-Laminat-Rahmensystem nach Anspruch 1, wobei der längliche PV-Rahmenabschnitt ferner einen zweiten Strömungskanal umfasst, der freiliegt, um ein Strömen des bei Raumtemperatur vulkanisierenden Silikons in der PV-Laminataufnahme (108, 208, 308, 408, 508, 608, 708) zu ermöglichen.

5. Photovoltaik-Laminat-Rahmensystem nach Anspruch 1, ferner umfassend einen PV-Laminatrand, der innerhalb der PV-Laminataufnahme (108, 208, 308, 408, 508, 608, 708) positioniert ist.

## Revendications

1. Système de cadre de panneau photovoltaïque stratifié comprenant : un premier panneau PV stratifié (101, 301, 501, 601) ayant une surface périphérique et une pluralité de cellules PV ; du silicone vulcanisant à température ambiante ; et une section de cadre allongée pour panneau PV comprenant : un récepteur de panneau PV stratifié (108, 208,308, 408, 508, 608, 708), le récepteur de panneau PV stratifié (108, 208,308, 408, 508, 608, 708) ayant une surface supérieure avec une longueur et une largeur, une surface inférieure ayant une longueur et une largeur, la surface inférieure étant espacée de la surface supérieure, une surface de connexion connectant la surface supérieure à la surface inférieure, un premier canal de flux (107, 207, 407) exposé pour permettre le flux de silicone vulcanisant à température ambiante dans le récepteur de panneau PV stratifié (108, 208,308, 408, 508, 608, 708), et un arrêt de stratifié (106, 206), l'arrêt de stratifié (106, 206) étant formé d'une seule pièce avec le récepteur de panneau PV stratifié (108, 208,308, 408, 508, 608, 708), dans lequel une partie du premier panneau PV stratifié (101, 301, 501, 601) est positionnée dans le récepteur de panneau PV stratifié (108, 208,308, 408, 508, 608, 708), dans lequel l'arrêt de stratifié (106, 206) empêche le mouvement du panneau PV stratifié (101, 301, 501, 601) vers au moins une surface interne du récepteur de panneau PV stratifié (108, 208,308, 408, 508, 608, 708), dans lequel le système de cadre de panneau photovoltaïque stratifié est **caractérisé en ce qu'**une largeur de la surface supérieure le long de la longueur de la surface supérieure n'est pas plus grande qu'une moitié de la largeur de la surface inférieure le long d'une majorité de la longueur de la surface inférieure, et dans lequel au moins des surfaces en regard de la surface inférieure et de la surface supérieure ne sont pas parallèles.

2. Système de cadre de panneau photovoltaïque stratifié selon la revendication **1,** dans lequel la section de cadre PV allongée comprend un alliage de métal.

3. Système de cadre de panneau photovoltaïque stratifié selon la revendication **1,** dans lequel le premier canal de flux (107, 207, 407) est positionné éloigné de la surface périphérique du premier panneau PV stratifié lorsque le panneau PV stratifié est logé dans le récepteur de panneau PV stratifié (108, 208,308, 408, 508, 608, 708).

4. Système de cadre de panneau photovoltaïque stratifié selon la revendication **1,** dans lequel la section de cadre PV allongée comprend en outre un deuxième canal de flux exposé pour permettre un flux de silicone vulcanisant à température ambiante dans le récepteur de panneau PV stratifié (108, 208,308, 408, 508, 608, 708).

5. Système de cadre de panneau photovoltaïque stratifié selon la revendication **1,** comprenant en outre un bord de panneau PV stratifié positionné dans le de silicone vulcanisant à température ambiante dans le récepteur de panneau PV stratifié (108, 208,308, 408, 508, 608, 708).
